# EUROPEAN PATENT SPECIFICATION

(11) **EP 4 102 946 B1**
(45) Date of publication and mention of the grant of the patent: **22.11.2023**
(21) Application number: 22178367.3
(22) Date of filing: 10.06.2022
(51) Int. Cl.: H05K 7/20, F24F 11/84, F24F 110/10, F25B 25/00

(54) **DISTRIBUTED COMPOSITE REFRIGERATION SYSTEM AND DATA CENTER**
VERTEILTES VERBUNDSTOFFKÜHLSYSTEM UND DATENZENTRUM
SYSTÈME DISTRIBUÉ DE RÉFRIGÉRATION COMPOSITE ET CENTRE DE DONNÉES

(30) Priority: 10.06.2021 CN 202110649030
(43) Date of publication of application: 14.12.2022
(73) Proprietor: Huawei Digital Power Technologies Co., Ltd., Shenzhen, 518043 (CN)
(72) Inventor: SONG, Jinliang, Shenzhen, 518129 (CN); ZHENG, Yao, Shenzhen, 518129 (CN)
(74) Representative: Gill Jennings & Every LLP

(56) References cited:
- CN-B- 110 351 986

## Description

### TECHNICAL FIELD

This application relates to the air conditioning refrigeration field, and in particular, to a distributed composite refrigeration system, and a data center equipped with the distributed composite refrigeration system.

### BACKGROUND

For a large indoor scenario with a heat source disposed, especially with heat sources disposed in a centralized manner, heat dissipation processing usually needs to be performed on an area in which the heat sources are located. A data center is used as an example. A large data center is equipped with a large quantity of servers. These servers generate a large amount of heat during running. A single-server refrigeration system cannot meet refrigeration requirements of the large data center. Therefore, a distributed data center refrigeration system needs to be introduced to implement overall refrigeration of the large data center by area, and ensure that servers in the data center can properly run in a preset temperature environment.

Most servers in the data center are uninterruptedly running. Therefore, the distributed data center refrigeration system needs to cooperatively operate for a long time to perform heat dissipation and cooling on the data center. An existing distributed data center refrigeration system cannot efficiently recycle heat, and a long-time operation of the distributed data center refrigeration system causes waste of resources.

CN 110351986 B describes a partitioned internal cooling type cabinet heat dissipation system with a composite cold source, and relates to the field of heat dissipation and energy saving systems. The system includes: a cabinet, a cooling tower and a refrigerator; a flow control pipeline is set at the water outlet of the cooling tower, and the low-temperature water output flow of the cooling tower and the refrigerator is regulated through the flow regulation pipeline; a heat exchange circulation pipeline is set on the refrigerator to cool the flow and heat exchange circulation loop is formed between the tower and the refrigerator through the flow control pipeline and the heat exchange circulation pipeline; the cabinet includes at least: the low load area A area, which includes at least the cabinet door of the A area and the air-cooled heat dissipation unit; the medium load area Zone B, which includes at least the cabinet doors of Zone B, the water-cooling heat dissipation unit of the medium-load zone, and the coolant circuit of the medium-load zone. Under the condition of ensuring the heat dissipation effect, the device realizes efficient utilization of energy and achieves the purpose of saving energy consumption.

### SUMMARY

The invention is defined by the features of claim 1. Further embodiments are defined in the dependent claims.

### BRIEF DESCRIPTION OF DRAWINGS

FIG. 1 is a schematic diagram of an application scenario of a distributed composite refrigeration system according to this application;
FIG. 2 is a schematic diagram of an actual application scenario of a distributed composite refrigeration system according to this application;
FIG. 3 is a schematic diagram of a first refrigeration unit in a distributed composite refrigeration system according to this application;
FIG. 4 is a schematic diagram of a circulation path of a first refrigeration unit in a distributed composite refrigeration system according to this application;
FIG. 5 is a schematic diagram of a circulation state of a refrigerant in a first refrigeration unit in a distributed composite refrigeration system according to this application;
FIG. 6 is a schematic diagram of a heat dissipation mode in a distributed composite refrigeration system according to this application;
FIG. 7 is a schematic diagram of another heat dissipation mode in a distributed composite refrigeration system according to this application;
FIG. 8 is a schematic diagram of still another heat dissipation mode in a distributed composite refrigeration system according to this application;
FIG. 9 is a schematic diagram of a structure of a multichannel heat exchanger in a distributed composite refrigeration system according to this application;
FIG. 10 is a schematic diagram of a structure of a multichannel heat exchanger in another distributed composite refrigeration system according to this application;
FIG. 11 is a schematic diagram of a cross-sectional structure of a multichannel heat exchanger in another distributed composite refrigeration system according to this application; and
FIG. 12 is a schematic diagram of an application scenario of another distributed composite refrigeration system according to this application.

### DESCRIPTION OF EMBODIMENTS

The following describes the technical solutions in embodiments of this application with reference to the accompanying drawings in embodiments of this application. It is clear that the described embodiments are merely some but not all of embodiments of this application. All other embodiments obtained by a person of ordinary skill in the art based on embodiments of this application without creative efforts shall fall within the protection scope of this application.

A distributed composite refrigeration system in this application may be used in an indoor environment with a heat source, and is particularly applicable to a large indoor environment in which heat sources are relatively scattered, for example, may be used in a large data center. The following uses a data center as an example.

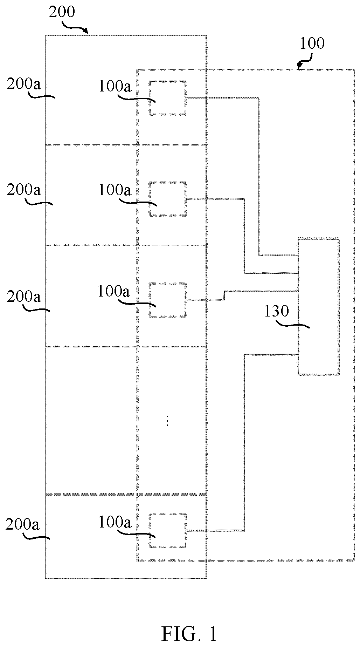

FIG. 1 is a schematic diagram of an application scenario in which a distributed composite refrigeration system 100 in this application is applied to a data center. The data center includes an equipment room 200, and at least one IT device (for example, a server 201) and/or a power supply apparatus are/is disposed in the equipment room 200. The at least one IT device and/or the power supply apparatus generate/generates a large amount of heat in a running process. In this application, the distributed composite refrigeration system 100 is configured to implement refrigeration and heat dissipation for the data center. The equipment room 200 is divided into a plurality of indoor areas 200a, and an IT device, a power supply apparatus, and/or the like are/is disposed in each indoor area 200a. The distributed composite refrigeration system 100 includes a plurality of refrigeration units 100a. Each refrigeration unit 100a is disposed at a position corresponding to one indoor area 200a, and is mainly configured to implement heat dissipation and cooling for the indoor area 200a. That is, all the refrigeration units 100a are correspondingly distributed at different positions based on positions of the indoor areas 200a in the equipment room 200, to separately perform heat dissipation and cooling for the different indoor areas 200a in the equipment room 200. In a schematic illustration of FIG. 1, the distributed composite refrigeration system 100 further includes a multichannel heat exchanger 130. The multichannel heat exchanger 130 is separately connected to each refrigeration unit 100a. The multichannel heat exchanger 130 may perform centralized heat dissipation on each refrigeration unit 100a. For details, refer to expanded descriptions in subsequent embodiments.

It should be noted that, in the schematic diagram of the application scenario shown in FIG. 1 in this embodiment of this application, a position of the refrigeration unit 100a in the composite refrigeration system 100 is merely a schematic illustration of a correspondence, and does not indicate that the refrigeration unit 100a is necessarily located inside the equipment room 200 of the data center. In specific implementation, the data center may be a micro-module data center, or may be a prefabricated data center, or may be a floor or room formed in a building for placing an IT server. Based on the data centers in the foregoing different forms, the distributed composite refrigeration system 100 may be disposed inside the equipment room 200 of the data center, or may be disposed outside the equipment room 200 of the data center, or may be partially disposed inside the equipment room 200 and partially disposed outside the equipment room 200.

In some implementation scenarios, in addition to the IT device and the power supply apparatus, a concept of the data center also includes a temperature control system and another matching device. Therefore, the distributed composite refrigeration system 100 in this embodiment of this application may also be considered as a part of the data center.

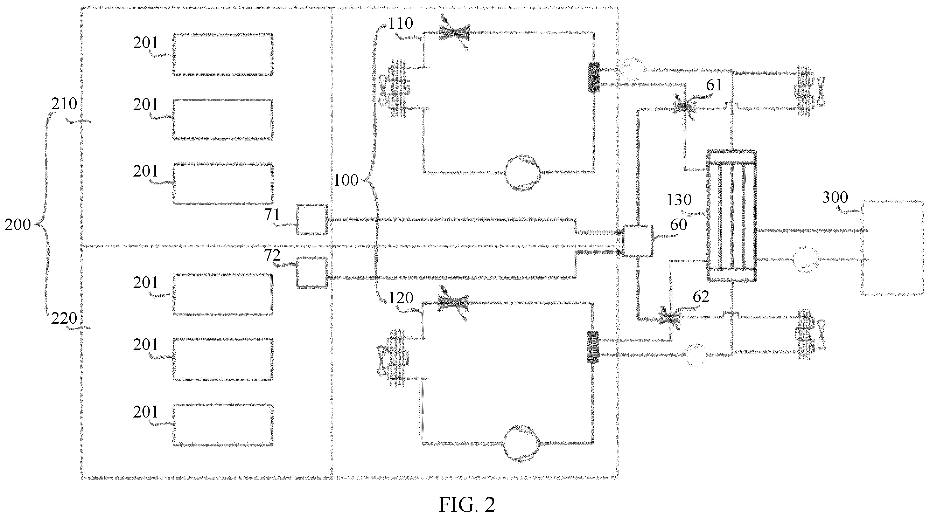

FIG. 2 is a schematic diagram of an actual scenario of an embodiment of the distributed composite refrigeration system 100 according to this application. In a schematic illustration of FIG. 2, the distributed composite refrigeration system 100 includes a first refrigeration unit 110, a second refrigeration unit 120, and the multichannel heat exchanger 130. The first refrigeration unit 110 and the second refrigeration unit 120 are distributed at different positions of the equipment room 200 of the data center, and both the first refrigeration unit 110 and the second refrigeration unit 120 are configured to perform refrigeration for the equipment room 200 of the data center. Specifically, the first refrigeration unit 110 and the second refrigeration unit 120 refrigerate air to be delivered to the equipment room 200 of the data center, and after the refrigerated air enters the equipment room 200 of the data center, the air is neutralized with air that is heated due to running of the server 201 in the equipment room 200 of the data center, to cool the equipment room 200 of the data center, and ensure that the server 201 operates in a preset temperature environment.

In this application, the distributed composite refrigeration system 100 may be applied to the equipment room 200 of a large data center. The relatively independent first refrigeration unit 110 and second refrigeration unit 120 act together to implement a good refrigeration effect on the equipment room 200 of the data center. The first refrigeration unit 110 and the second refrigeration unit 120 are distributed at different positions of the equipment room 200 of the data center, and separately refrigerate air to be delivered to different indoor areas in the equipment room 200 of the data center, so that an overall temperature of the equipment room 200 of the data center is more balanced. Servers 201 disposed at different positions of the equipment room 200 of the data center may operate in the preset temperature environment. A single refrigeration system has a limited refrigeration amount, and a reliable refrigeration scenario cannot be formed for the equipment room 200 of the large data center. The distributed composite refrigeration system 100 in this application has a better refrigeration effect.

In the schematic illustration of FIG. 2, the equipment room 200 of the data center may be divided into a first area 210 and a second area 220. The first refrigeration unit 110 refrigerates air to be delivered mainly to the first area 210, and the second refrigeration unit 120 refrigerates air to be delivered mainly to the second area 220. The first area 210 and the second area 220 may be spatial areas that are connected, or may be spatial areas that are independent of each other. In other words, the equipment room 200 of the data center may be an integral equipment room, or may be implemented by using isolated independent equipment rooms. When the first area 210 and the second area 220 are spatial areas that are connected, the air refrigerated by the first refrigeration unit 110 may partially flow into the second area 220, and the air refrigerated by the second refrigeration unit 120 may partially flow into the first area 210.

It can be understood that, due to an area difference of the equipment room 200 of the data center and a density difference of actually arranged servers 201 in the equipment room 200 of the data center, the equipment room 200 of the data center may be further divided into a third area, a fourth area, or more areas. Correspondingly, a quantity of refrigeration units in the refrigeration system 100 of this application may further be three, four, or above. Each refrigeration unit is disposed in a distributed manner, and separately performs refrigeration for each area.

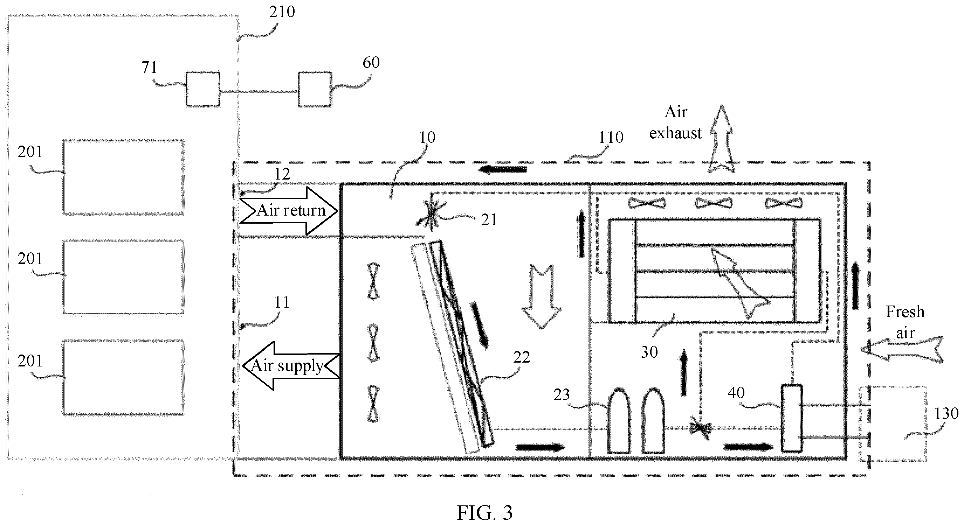

Refer to a specific structure of the first refrigeration unit 110 shown in FIG. 3. The distributed composite refrigeration system 100 includes a circulation air duct 10. The circulation air duct 10 includes an air supply vent 11 and an air exhaust vent 12. The air supply vent 11 and the air exhaust vent 12 are separately connected to the equipment room 200 of the data center. The air supply vent 11 is configured to deliver cooled air (denoted as "air supply" in the figure) into the equipment room 200 of the data center. The air exhaust vent 12 is configured to suck air in the equipment room 200 of the data center into the circulation air duct 10 (denoted as "air return" in the figure), and cool this part of air. Therefore, the equipment room 200 of the data center and the circulation air duct 10 form a sealed circulation air path. As shown in FIG. 3, the circulation air path may be disposed separately corresponding to the first area 210, or may act on both the first area 210 and the second area 220. That is, there may be a plurality of circulation air ducts 10, and each refrigeration unit is correspondingly disposed to refrigerate air in one circulation air duct 10. Alternatively, there are a plurality of air supply vents 11 and a plurality of air exhaust vents 12, and after the circulation air duct 10 sucks returned air in each area through the plurality of air exhaust vents 12 in a unified manner, the circulation air duct 10 distributes the returned air to each refrigeration unit for refrigeration, and delivers the refrigerated returned air to the respective areas from the respective air supply vents 11.

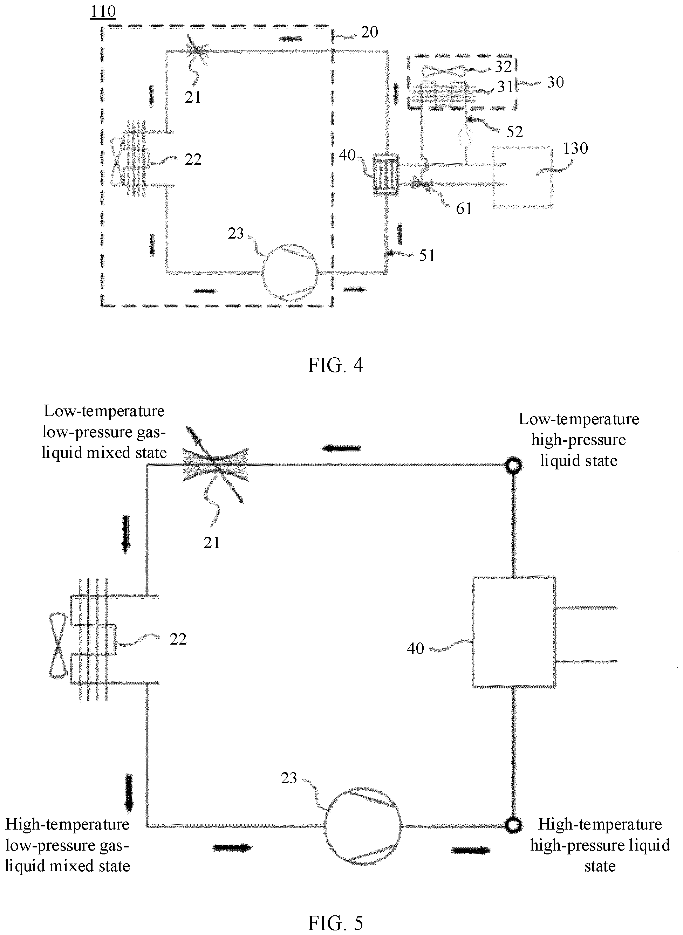

Refer to FIG. 4. The first refrigeration unit 110 includes a refrigeration part 20, a heat exchange part 40, and a heat dissipation unit 30. The refrigeration part 20 and the heat exchange part 40 are connected through a first pipe 51 to form a circulating refrigeration path, and a refrigerant flows in the circulating refrigeration path. The refrigeration part 20 refrigerates supplied air by using the refrigerant. The refrigerant may be implemented by using a refrigeration medium, such as Freon (fluorine, chlorine, and bromine derivatives of saturated hydrocarbons), an azeotropic mixed working substance (an azeotropic solution formed by two kinds of Freon at a specific ratio), a hydrocarbon (propane, ethylene, or the like), ammonia, or the like. These refrigeration media can implement liquidation and facilitate refrigeration at a normal temperature or a low temperature.

The heat exchange part 40 and the heat dissipation part 30 are connected through a second pipe 52 to form a circulating heat exchange path, and an intermediate medium flows in the circulating heat exchange path. In some embodiments, the intermediate medium may be water or a thermally conductive solvent. The intermediate medium and the refrigerant flow to the heat exchange part 40, and implement heat exchange in the heat exchange part 40. Specifically, a process in which the refrigeration part 20 cools the supplied air by using the refrigerant can be understood as a process in which the refrigerant performs heat exchange with the supplied air. A temperature of the refrigerant that completes the cooling in the refrigeration part 20 increases. The refrigeration part 20 includes an electronic expansion valve 21, an evaporator 22, and a compressor 23 that are sequentially connected. The electronic expansion valve 21 is configured to throttle and depressurize the refrigerant. The evaporator 22 is configured to make the refrigerant evaporate to absorb heat, so as to implement heat exchange between the refrigerant and the supplied air. The compressor 23 is configured to pressurize the refrigerant.

With reference to a schematic illustration of a state and a temperature of the refrigerant in the circulating refrigeration path shown in FIG. 5, the refrigerant performs heat exchange with the intermediate medium at the heat exchange part 40. Therefore, a temperature of the refrigerant flowing into the electronic expansion valve 21 is low, and the refrigerant is in a low-temperature high-pressure liquid state. After the electronic expansion valve 21 throttles and depressurizes the refrigerant, the refrigerant is converted from the low-pressure liquid state to a low-pressure gas-liquid mixed state, and the temperature remains low. The evaporator 22 makes the refrigerant evaporate to absorb heat, and then the refrigerant is in a high-temperature low-pressure gas-liquid mixed state, and in some scenarios, the refrigerant is directly in a high-temperature low-pressure gas state. The compressor 23 exerts pressure on the refrigerant to convert the refrigerant from the gas state or the gas-liquid mixed state into a high-temperature high-pressure liquid state. In this way, the refrigerant completes a cycle of refrigeration operation in the refrigeration path formed by the refrigeration part 20 and the heat exchange part 40.

Still refer to a schematic illustration on one side of the heat exchange part 40 and the heat dissipation part 30 in FIG. 4. The heat exchange part 40 and the heat dissipation part 30 are connected through the second pipe 52, and the intermediate medium that flows through the heat exchange part 40 to complete heat exchange with the refrigerant may flow to the heat dissipation part 30 for heat dissipation. In the schematic illustration of FIG. 4, the heat dissipation part 30 includes a heat dissipation fin 31 and a fan 32. In a process in which the intermediate medium flows through the heat dissipation fin 31, a heat dissipation area of the intermediate medium is increased, and a good heat dissipation effect of the intermediate medium can be implemented with assistance by fast flowing air provided by the fan 32. Refer to FIG. 3. External air (denoted as "fresh air" in the figure) is further introduced into the heat dissipation part 30, flows through the heat dissipation fin 31 under action of the fan 32, and then flows out of the heat dissipation part (denoted as "air exhaust" in the figure) from the other side of the heat dissipation fin 31. The intermediate medium obtained after heat dissipation flows back to the heat exchange part 40 to implement heat exchange operation with the refrigerant again.

Still refer to FIG. 2. In the distributed composite refrigeration system 100 in this application, the multichannel heat exchanger 130 is further connected to the heat dissipation part 30 of the first refrigeration unit 110 in parallel, and the intermediate medium flowing out of the heat exchange part 40 may further flow into the multichannel heat exchanger 130 for heat dissipation. Specifically, the multichannel heat exchanger 130 is thermally connected to an external pipe network 300. The intermediate medium may perform heat exchange with the external pipe network 300 when flowing through the multichannel heat exchanger 130. Specifically, a heat carrying body flows in the external pipe network 300, and the refrigerant may perform heat exchange with the heat carrying body in the external pipe network 300. A high temperature of the refrigerant may be transferred to the heat carrying body with a relatively low temperature, that is, after the refrigerant heats the heat carrying body, the temperature of the refrigerant decreases to implement a heat dissipation effect, and the temperature of the heat carrying body increases. The external pipe network 300 may be connected to a local heating pipe, a hot water pipe, or the like, and correspondingly, the heat carrying body thereof may be water, and may serve as heating water or domestic hot water.

That is, the first refrigeration unit 110 includes three heat dissipation modes: In a first heat dissipation mode, the first refrigeration unit 110 independently heats the intermediate medium by using the heat dissipation part 30. In a second heat dissipation mode, the first refrigeration unit 110 separately performs heat exchange with the external pipe network 300 by using the multichannel heat exchanger 130, and exchanges heat of the intermediate medium to the heat carrying body to implement heat dissipation. In a third heat dissipation mode, the first refrigeration unit 110 performs heat dissipation on the intermediate medium by using both the heat dissipation part 30 and the multichannel heat exchanger 130. It can be understood that, in the third heat dissipation mode, the second pipeline 52 is controlled, so that one part of the intermediate medium flows into the heat dissipation part 30 for heat dissipation, and the other part of the intermediate medium flows into the multichannel heat exchanger 130 for heat dissipation.

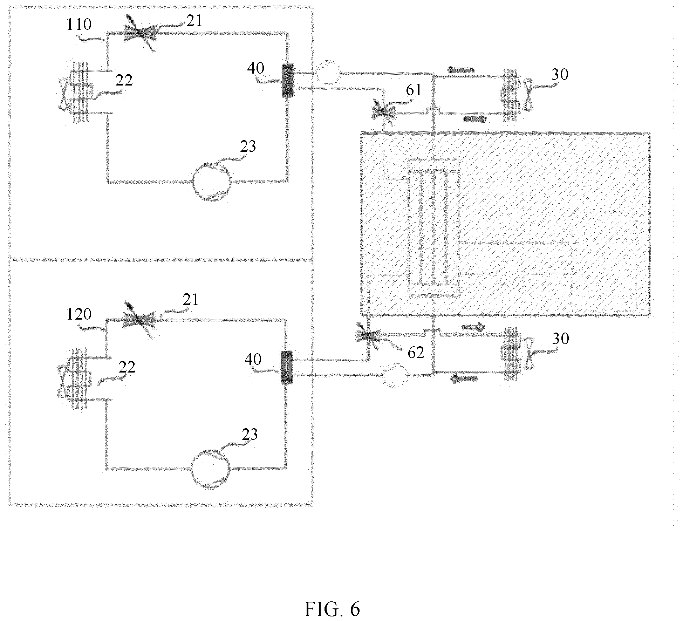

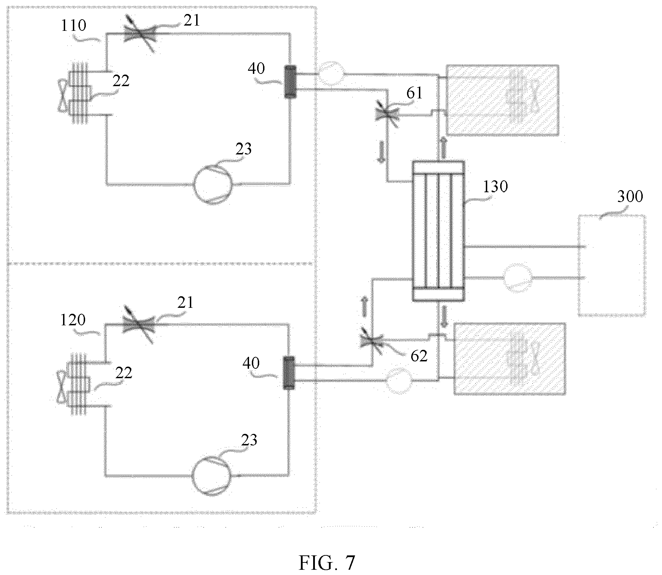

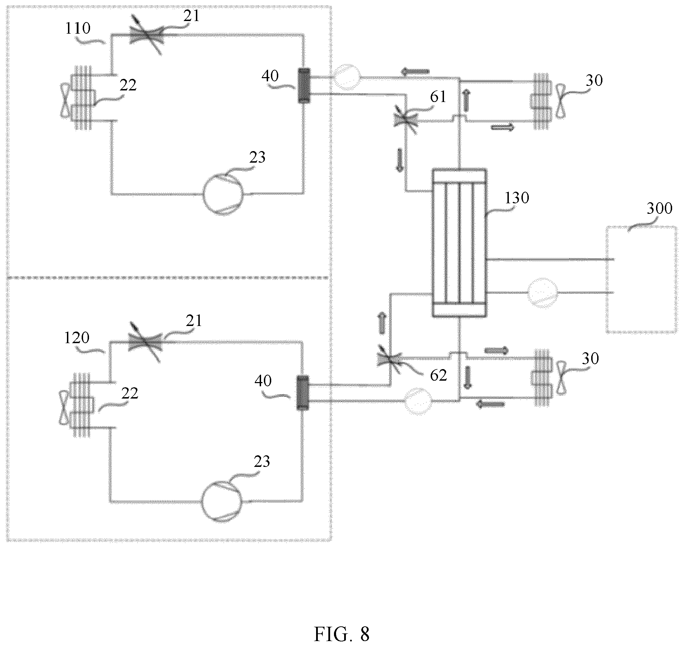

For the distributed composite refrigeration system 100 in this application, the multichannel heat exchanger 130 is connected in parallel to the heat dissipation parts 30 of a plurality of refrigeration units, that is, the plurality of refrigeration units may all cooperate with the multichannel heat exchanger 130. Refer to FIG. 6. When both the first refrigeration unit 110 and the second refrigeration unit 120 use the first heat dissipation mode, no intermediate medium flows into the multichannel heat exchanger 130, and each refrigeration unit implements heat dissipation on the intermediate medium by using the respective heat dissipation part 30 (a gray arrow in the figure indicates a flow direction of the intermediate medium). However, in a schematic illustration of FIG. 7, both the first refrigeration unit 110 and the second refrigeration unit 120 use the second heat dissipation mode for heat dissipation: The intermediate mediums in the two refrigeration units flow into the multichannel heat exchanger 130, and implement heat exchange with the heat carrying body in the external pipe network 300. In a schematic illustration of FIG. 8, both the first refrigeration unit 110 and the second refrigeration unit 120 use the third heat dissipation mode for heat dissipation, and at least a part of each of the intermediate mediums in the two refrigeration units flows into the multichannel heat exchanger 130 for heat exchange with the heat carrying body.

It can be learned that, in the schematic illustrations in FIG. 7 and FIG. 8, when each refrigeration unit uses the second heat dissipation mode or the third heat dissipation mode, the intermediate medium can perform heat exchange with the heat carrying body in the external pipe network 300. That is, in addition to performing refrigeration and heat dissipation for the equipment room 200 of the data center, the distributed composite refrigeration system 100 in this application transfers at least part of heat generated in a refrigeration process to the external pipe network 300 by using the multichannel heat exchanger 130, so that energy recycle is implemented. Compared with an embodiment of another solution in which direct heat dissipation is performed entirely by using the heat dissipation part 30 of each refrigeration unit, the distributed composite refrigeration system 100 in this application implements better energy conservation and environment protection.

For example, calculation is performed based on a case in which heat generated by the composite refrigeration system 100 in one-hour refrigeration is 80 kWh. After each refrigeration unit in the composite refrigeration system 100 operates in the second heat dissipation mode for two hours, the composite refrigeration system 100 can provide heat of 160 kWh to the external pipe network 300. When each refrigeration unit in the composite refrigeration system 100 operates in the second heat dissipation mode all day, the composite refrigeration system 100 can provide heat of 1920 kWh to the external pipe network 300. This part of heat can form a good heating effect for the external pipe network 300.

It should be noted that, FIG. 3 to FIG. 8 specifically describe the structure of the first refrigeration unit 110. The actual second refrigeration unit 120 may also be deployed based on the solutions of the foregoing embodiments, and implement heat dissipation and cooling for the equipment room 200 with the first refrigeration unit 110. When there are a plurality of refrigeration units, each refrigeration unit may also be deployed based on embodiments in FIG. 3 to FIG. 8. A structure of the second refrigeration unit 120 or a remaining refrigeration unit is not described herein again in this application.

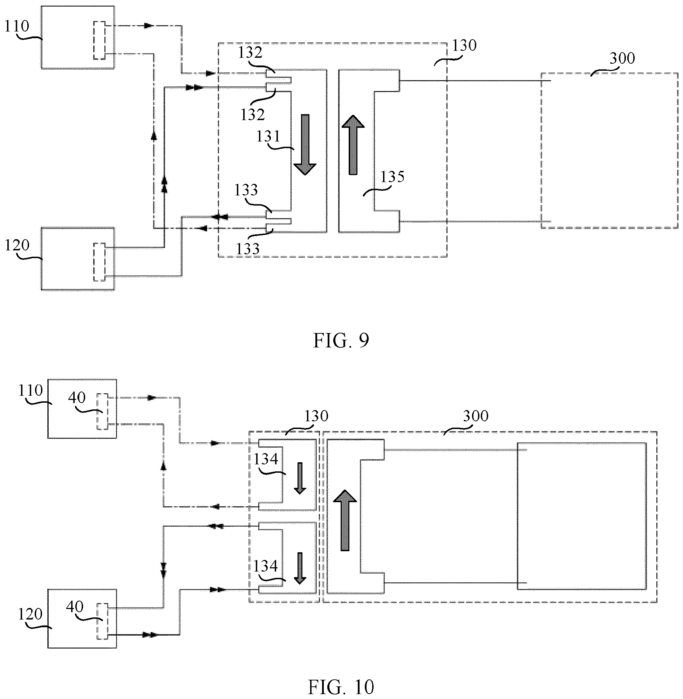

Refer to a schematic illustration of FIG. 9, inside the multichannel heat exchanger 130. A heat exchange channel 131 is included inside the multichannel heat exchanger 130. The heat exchange channel 131 has two inlets 132 and two outlets 133. One inlet 132 and one outlet 133 are connected to a heat exchanger 40 of the first refrigeration unit 110, and are configured to enable the intermediate medium in the first refrigeration unit 110 to flow through the heat exchange channel 131. The other inlet 132 and the other outlet 133 are connected to a heat exchanger 40 of the second refrigeration unit 120, and are configured to enable the intermediate medium in the second refrigeration unit 120 to flow through the heat exchange channel 131. The intermediate medium in the first refrigeration unit 110 and the intermediate medium in the second refrigeration unit 120 converge in the heat exchange channel 131, perform heat exchange with the heat carrying body, then diverge at the two outlets 133, and separately flow back to the first refrigeration unit 110 and the second refrigeration unit 120.

It can be understood that, when there are a plurality of refrigeration units, quantities of inlets 132 and outlets 133 of the heat exchange channel 131 also accordingly increase, and each refrigeration unit is connected to the heat exchange channel 131 through one inlet 132 and one outlet 133. In this embodiment, the intermediate mediums in the refrigeration units converge in the heat exchange channel 131. If the intermediate mediums in the refrigeration units have different temperatures, temperatures of the converged intermediate mediums tend to be consistent, and temperatures of the intermediate mediums obtained after heat exchange with the heat carrying body are also relatively consistent. This is conducive to controlling a heating temperature caused by the intermediate medium to the heat carrying body, and improving heat exchange efficiency between the intermediate medium and the heat carrying body.

In a schematic illustration of FIG. 10, the multichannel heat exchanger 130 includes two sub-heat exchange channels 134 inside. One sub-heat exchange channel 134 is connected to the first refrigeration unit 110, and the other sub-heat exchange channel 134 is connected to the second refrigeration unit 120. The intermediate medium in the first refrigeration unit 110 and the intermediate medium of the second refrigeration unit 120 respectively complete heat exchange with the heat carrying body in a process of flowing through the sub-heat exchange channels 134, and then respectively flow back to the first refrigeration unit 110 and the second refrigeration unit 120 through the sub-heat exchange channels 134.

It can be understood that, when there are a plurality of refrigeration units, a quantity of sub-heat exchange channels 134 also accordingly increases. Each refrigeration unit may be connected by using one sub-heat exchange channel 134, and the intermediate medium of each refrigeration unit also completes heat exchange with the heat carrying body in the sub-heat exchange channel 134. In this embodiment, the multichannel heat exchanger 130 does not need to perform traffic distribution on the intermediate medium obtained after heat exchange, and the intermediate medium of each refrigeration unit may flow back along the sub-heat exchange channel 134 correspondingly connected to the refrigeration unit. This facilitates traffic control on a single refrigeration unit, and ensures a heat dissipation effect of an intermediate medium of the single refrigeration unit.

In addition, in the embodiment of FIG. 9, the multichannel heat exchanger 130 is also provided with a heat carrying body channel 135. The heat carrying body channel 135 is connected to the external pipe network 300, and the heat carrying body directly flows into the heat carrying body channel 135. The heat carrying body channel 135 and the heat exchange channel 131 are independent of but close to each other, and the heat carrying body in the heat carrying body channel 135 and the intermediate medium in the heat exchange channel 131 implement heat exchange. In an embodiment, a flow direction of the intermediate medium in the heat exchange channel 131 is opposite to a flow direction of the heat carrying body in the heat carrying body channel 135 (indicated by two side-by-side gray arrows in FIG. 9). In this case, when the intermediate medium flows through the heat exchange channel 131, a temperature difference between the intermediate medium and the heat carrying body 135 is large. This can improve heat exchange efficiency. In some other embodiments, the flow direction of the intermediate medium may be the same as that of the heat carrying body.

However, in the embodiment shown in FIG. 10, the heat carrying body does not flow into the multichannel heat exchanger 130, and the external pipe network 300 is directly close to the multichannel heat exchanger 130, to implement a heat exchange function between the heat carrying body and the intermediate medium. In the schematic illustration of FIG. 10, the two sub-heat exchange channels 134 are disposed side by side along a length direction of the external pipe network 300. It can be understood that, a flow direction of the intermediate medium in each sub-heat exchange channel 134 is also opposite to a flow direction of the heat carrying body in the external pipe network 300 (indicated by three gray arrows in FIG. 10), so as to increase a temperature difference between the intermediate medium and the heat carrying body, and improve heat exchange efficiency. In some other embodiments, flow directions of the intermediate medium and the heat carrying body may alternatively be the same. In some other embodiments, the two sub-heat exchange channels 134 may be further stacked at upper and lower layers along the length direction of the external pipe network 300, to increase an action area between each sub-heat exchange channel 134 and the external pipe network 300.

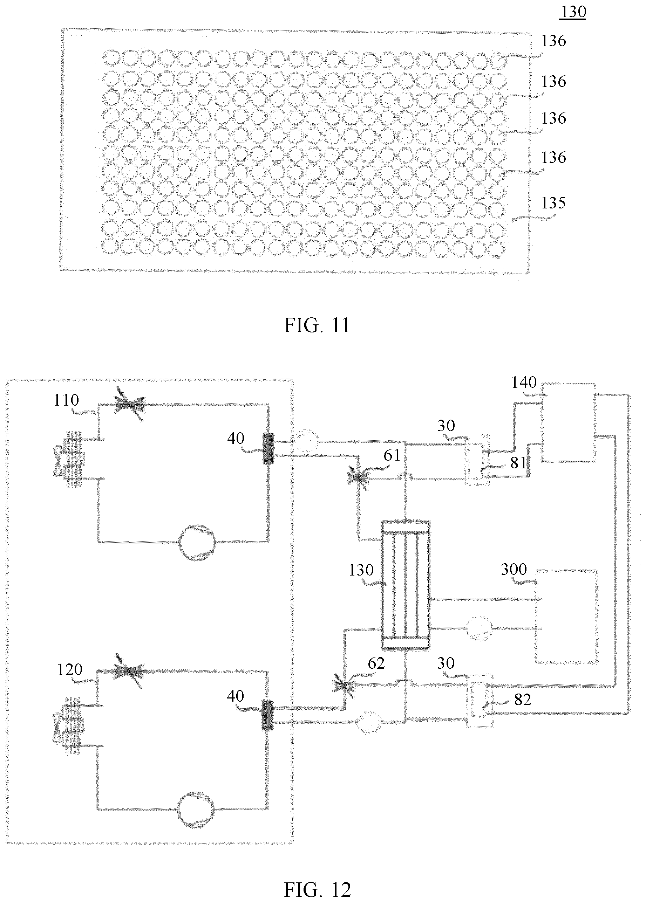

FIG. 11 shows an embodiment. In this embodiment, the multichannel heat exchanger 130 includes a plurality of diverging heat exchange channels 136 and an integral heat carrying body channel 135. The integral heat carrying body channel 135 is disposed by enclosing peripheries of the plurality of diverging heat exchange channels 136, that is, the plurality of diverging heat exchange channels 136 run through the integral heat carrying body channel 135, and the diverging heat exchange channels 136 are isolated from the integral heat carrying body channel 135. In this embodiment, a heat carrying body circulates at an outer peripheral position of each diverging heat exchange channel 136. Therefore, a contact area between each diverging heat exchange channel 136 and the heat carrying body is increased, and this can form a better heat exchange effect for each diverging heat exchange channel 136.

A pipe diameter of the diverging heat exchange channel 136 may be set to be relatively small, so that the intermediate medium of same traffic can form a larger contact area with the heat carrying body. In some embodiments, the pipe diameter of the diverging heat exchange channel 136 may be less than or equal to 1 mm. The plurality of diverging heat exchange channels 136 may be configured to form the heat exchange channel 131 shown in FIG. 9, or may be configured to form each sub-heat exchange channel 134 shown in FIG. 10. In other words, the diverging heat exchange channels 136 may be jointly configured to form the heat exchange channel 131. After converging in the multichannel heat exchanger 130, the intermediate medium in each refrigeration unit is diverged to each diverging heat exchange channel 136 for heat dissipation. Alternatively, each diverging heat exchange channel 136 may be connected to each refrigeration unit, and several diverging heat exchange channels 136 are configured to form one sub-heat exchange channel 134. The intermediate medium in each refrigeration unit may alternatively be directly diverged to each diverging heat exchange channel 136, and flow back to the respective refrigeration unit after heat exchange.

The foregoing plurality of manners all implement a thermally conductive connection between the multichannel heat exchanger 130 and the external pipe network 300, and heat exchange may be formed between the heat carrying body and the intermediate medium. In addition, for a structure of a single heat exchange channel 131 in the embodiment of FIG. 9, the external pipe network 300 may directly approach the multichannel heat exchanger 130 to implement the thermally conductive connection in between. Alternatively, the manner shown in FIG. 11 may be used, so that a single heat exchange channel 131 runs through the heat carrying body channel 135 to increase a contact area. For a structure of the plurality of sub-heat exchange channels 131 in the embodiment in FIG. 10, the thermally conductive connection between the external pipe network 300 and the multichannel heat exchanger 130 may also be implemented in a manner of cooperating with the heat carrying body channel 135.

In an embodiment, refer to FIG. 2. The first refrigeration unit 110 further includes a first three-way valve 61. The first three-way valve 61 is connected between the multichannel heat exchanger 130 and the heat exchanger 40 and the heat dissipation part 30 of the first refrigeration unit 110, and is configured to adjust a heat dissipation mode of the first refrigeration unit 110. Specifically, the first three-way valve 61 has a first liquid inlet and two first liquid outlets. The first liquid inlet is connected to the heat exchanger 40 of the first refrigeration unit 110, one first liquid outlet is connected to the heat dissipation part 30 of the first refrigeration unit 110, and the other first liquid outlet is connected to the multichannel heat exchanger 130. Therefore, the intermediate medium that completes heat exchange with a refrigerant in the heat exchanger 40 may enter the first three-way valve 61 from the first liquid inlet, and then separately flow to the heat dissipation part 30 and the multichannel heat exchanger 130 from the two first liquid outlets. It can be understood that, traffic of the intermediate medium that flows into the first three-way valve 61 from the first liquid inlet is equal to a sum of traffic of the intermediate medium that flows out of the first three-way valve 61 from the two first liquid outlets.

In some embodiments, respective traffic of the two first liquid outlets of the first three-way valve 61 may be regulated. In this application, the distributed composite refrigeration system 100 is further provided with a controller 60 (refer to FIG. 2). The controller 60 is electrically connected to the first three-way valve 61, and is configured to control operation of the first three-way valve 61. The controller 60 may control the first three-way valve 61 to distribute traffic of the intermediate medium that flows into the heat dissipation part 30 and traffic of the intermediate medium that flows into the multichannel heat exchanger 130.

The controller 60 may distribute the traffic of the intermediate medium based on a heat dissipation requirement of the intermediate medium, or based on a heating temperature required by the heat carrying body. For example, a heat dissipation effect of the heat dissipation part 30 is usually better than that of the multichannel heat exchanger 130. If a temperature of the intermediate medium is high, the controller 60 may control the first three-way valve 61, so that more of the intermediate medium flows into the heat dissipation part 30 for heat dissipation. In some embodiments, the controller 60 may further be communicatively connected to the heat dissipation part 30, and control a rotational speed of the fan 32 of the heat dissipation part 30, so as to control a heat dissipation capability of the heat dissipation part 30.

Traffic distribution of the intermediate medium that is controlled by the controller 60 based on the heating temperature required by the heat carrying body may be described based on the following scenario: On a premise that a flow rate of the heat carrying body in the external pipe network 300 is fixed, if an external ambient temperature is low, an initial temperature of the heat carrying body is lower before heat exchange between the heat carrying body and the intermediate medium at the multichannel heat exchanger 130. In this case, the control by the controller 60 enables more traffic of the intermediate medium to flow into the multichannel heat exchanger 130, and a heating temperature caused by the intermediate medium to the heat carrying body increases, so that a temperature rise obtained after heat exchange of the heat carrying body is larger. If the external ambient temperature is high, the control by the controller 60 enables less traffic of the intermediate medium to flow into the multichannel heat exchanger 130, so that a temperature rise obtained after heat exchange of the heat carrying body is smaller.

The foregoing application scenario related to the external ambient temperature may be used to seasonally regulate a heat dissipation manner of the distributed composite refrigeration system 100 in this application. For example, in winter when the external ambient temperature is low, the controller 60 may control more of the intermediate medium to flow into the multichannel heat exchanger 130, so that the heat carrying body with a low temperature in the external pipe network 300 obtains a larger temperature rise by heat exchange. However, in summer when the external ambient temperature is high, the controller 60 may control more of the intermediate medium to flow into the heat dissipation part 30, so that the intermediate medium obtains a better heat dissipation effect. It can be understood that, when the external pipe network 300 is a heating pipe network, the external pipe network 300 does not need to operate in summer, and therefore the heat carrying body does not need to form heat exchange with the composite refrigeration system 100. When the external pipe network 300 is a hot water pipe, an amount of hot water used in summer and a temperature of the hot water used in summer accordingly decrease, and the heating temperature required by the heat carrying body also accordingly decreases.

In an embodiment, refer to FIG. 2. The first refrigeration unit 110 is further provided with a first temperature sensor 71. The first temperature sensor 71 is disposed in the equipment room 200 of the data center, and is configured to monitor a temperature of the first area 210. The first temperature sensor 71 is communicatively connected to the controller 60 to transmit a detected temperature value of the first area 210 to the controller 60. After receiving the temperature value, the controller 60 may control the first three-way valve 61 to distribute traffic of the refrigerant.

Specifically, in this embodiment, a temperature drop caused by the refrigeration part 20 to supplied air to be delivered to the first area 210 can be determined by using a real-time temperature value of the first area 210 that is detected by the first temperature sensor 71. The first refrigeration unit 110 mainly performs refrigeration for the first area 210. Therefore, when the temperature value of the first area 210 is low, a temperature drop caused by the refrigeration part 20 of the first refrigeration unit 110 to the air by using the refrigerant accordingly decreases. In this case, heat absorbed by the refrigerant in the refrigeration part 20 by evaporation also accordingly decreases, and a temperature rise of the refrigerant in a refrigeration process accordingly decreases. Therefore, heat that the refrigerant can supply to the intermediate medium by exchange in the heat exchange part 40 accordingly decreases, and a heating effect of the intermediate medium is reduced. In this case, the controller 60 controls the first three-way valve 61 to distribute more of the intermediate medium for flowing into the multichannel heat exchanger 130, so as to provide more exchangeable heat for the heat carrying body, thereby maintaining a heating effect of the intermediate medium on the heat carrying body. Conversely, when the real-time temperature value of the first area 210 that is detected by the first temperature sensor 71 is high, the heat that the refrigerant can supply to the intermediate medium in the heat exchange part 40 increases. In this case, the controller 60 controls the first three-way valve 61 to distribute more of the intermediate medium for flowing into the heat dissipation part 30 for direct heat dissipation. The intermediate medium in the multichannel heat exchanger 130 provides less exchangeable heat, and a heating effect on the heat carrying body is more balanced.

In an embodiment, the controller 60 is further communicatively connected to the server 201 in the equipment room 200 of the data center, to monitor a real-time workload of the server 201 in the first area 210, and then controls refrigerant traffic distribution of the first three-way valve 61 based on the workload. Specifically, the temperature of the first area 210 is further related to the workload of the server 201 in the area. When the server 201 in the first area 210 has a heavy workload, heat generated when the server 201 operates is high. The first refrigeration unit 110 needs to increase its refrigeration intensity, to decrease a temperature of air to be delivered to the first area 210, so that an overall ambient temperature of the equipment room 200 of the data center is balanced. An ambient temperature of the first area 210 does not increase due to an increase of the workload of the server 201 in the area, and overall operating efficiency of the equipment room 200 of the data center is not affected.

It can be understood that, the refrigeration intensity of the first refrigeration unit 110 is increased, and a temperature of the intermediate medium flowing out of the heat exchange part 40 of the first refrigeration unit 110 also accordingly increases. In this case, the controller 60 needs to distribute more of the intermediate medium to the heat dissipation part 30 for heat dissipation, to reduce traffic of the intermediate medium in the multichannel heat exchanger 130. Such control can make heat provided by the intermediate medium in the multichannel heat exchanger 130 to the heat carrying body relatively fixed, and the heat carrying body does not obtain more heat as the temperature of the intermediate medium increases, ensuring that the heating effect on the heat carrying body is more balanced. Conversely, when the workload of the server 201 in the first area 210 is light, heat generated in an operating process of the server 201 is relatively low, and the refrigeration intensity of the first refrigeration unit 110 for refrigerating the air by using the refrigerant decreases. In this case, the controller 60 may distribute more of the intermediate medium for flowing into the multichannel heat exchanger 130, to maintain the heating effect of the intermediate medium on the heat carrying body.

Because there may be a plurality of servers 201 in the first area 210, a communication connection between the controller 60 and the equipment room 200 of the data center may be that the controller 60 is separately communicatively connected to the plurality of servers 201 in the first area 210, separately monitors workloads of the servers 201, and finally distributes the traffic of the refrigerant in a manner of averaging.

In some other implementations, the controller 60 may further receive the temperature value of the first area 210 that is detected by the first temperature sensor 71 and workload data of the server 201 in the first area 210 at the same time, and control traffic distribution of the first three-way valve 61 based on the temperature value and the workload data, to ensure both a refrigeration effect of the first area 210 and the heating effect on the heat carrying body.

It should be noted that, in the foregoing embodiment, the first three-way valve 61 may alternatively be replaced with two solenoid valves (not shown in the figure). One solenoid valve is connected between the heat exchanger 40 and the heat dissipation part 30, and the other solenoid valve is connected between the heat exchanger 40 and the multichannel heat exchanger 130. The controller 60 is configured to simultaneously control the two solenoid valves for linkage, and this can also implement the foregoing traffic distribution effect.

The foregoing plurality of manners of cooperation between the first refrigeration unit 110 and the multichannel heat exchanger 130 may also be applied to cooperation between another refrigeration unit and the multichannel heat exchanger 130, so that the controller 60 can separately control traffic of the intermediate medium in each refrigeration unit, to further control total traffic of the intermediate medium at the multichannel heat exchanger 130 and the heating effect of the intermediate medium on the heat carrying body. In addition, the controller 60 may further control a heat dissipation effect of each refrigeration unit.

In the schematic illustration of FIG. 2, the second refrigeration unit 120 may include a second three-way valve 62. The second three-way valve 62 is connected between the multichannel heat exchanger 130 and the heat exchange part 40 and the heat dissipation part 30 of the second refrigeration unit 120. The second three-way valve 62 is also connected to the controller 60, and the controller 60 controls traffic distribution of the intermediate medium flowing out of the heat exchange part 40 of the second refrigeration unit 120.

In an embodiment, the second refrigeration unit 120 is provided with a second temperature sensor 72. The second temperature sensor 72 is disposed in the second area 220 of the equipment room 200 of the data center, and is configured to monitor a temperature of the second area 220. The second three-way valve 62 is mainly configured to perform refrigeration for the second area 220. Therefore, after receiving a temperature value of the second area 220 that is detected by the second temperature sensor 72, the controller 60 may control the second three-way valve 62 to distribute traffic of the intermediate medium.

In some embodiments, the controller 60 may also be communicatively connected to the equipment room 200 of the data center to monitor a real-time workload of the server 201 in the second area 220, and then control traffic distribution of the intermediate medium of the second three-way valve 62 based on the workload. The controller 60 may further receive the temperature value detected by the second temperature sensor 72 and workload data of the server 201 in the second area 220 at the same time, to distribute the traffic of the intermediate medium, so as to ensure both a refrigeration effect of the second refrigeration unit 120 and the heating effect of the intermediate medium. In some embodiments, the second three-way valve 62 may alternatively be replaced with two solenoid valves.

In another aspect, when the distributed composite refrigeration system 100 in this application is applied to another operation scenario other than a data center, the controller 60 may also be communicatively connected to a heat source in the operation scenario, and accordingly regulate traffic distribution operation of an intermediate medium by monitoring a workload of the heat source in real time, so as to accordingly control a heat dissipation effect of each refrigeration unit.

In an embodiment, the controller 60 may match and regulate traffic distribution of the first three-way valve 61 and the second three-way valve 62, to control overall traffic and an overall temperature of the intermediate medium flowing into the multichannel heat exchanger 130, thereby accurately controlling a heating temperature of the heat carrying body. Specifically, a temperature difference may exist between the intermediate medium flowing out of the first refrigeration unit 110 and the intermediate medium flowing out of the second refrigeration unit 120. The controller 60 may determine the temperature difference between the intermediate medium flowing out of the first refrigeration unit 110 and the intermediate medium flowing out of the second refrigeration unit 120 by separately communicatively connecting to the first temperature sensor 71 and the second temperature sensor 72, and/or by separately monitoring the workload of the server 201 in the first area 210 and the workload of the server 201 in the second area 220. Further, by matching and regulating the traffic distribution of the first three-way valve 61 and the second three-way valve 62, the controller 60 can control a ratio of the traffic of the intermediate medium that flows from the first refrigeration unit 110 to the multichannel heat exchanger 130, to the traffic of the intermediate medium that flows from the second refrigeration unit 120 into the multichannel heat exchanger 130. Therefore, the controller 60 can control the overall temperature of the intermediate medium flowing into the multichannel heat exchanger 130, and further control the heating temperature caused by the intermediate medium to the heat carrying body.

Corresponding to the embodiment in which the multichannel heat exchanger 130 includes the heat exchange channel 131, after the intermediate medium flowing from the first refrigeration unit 110 and the intermediate medium flowing from the second refrigeration unit 120 converge, overall temperatures of the intermediate mediums tend to be consistent, and the controller 60 can directly control the heating temperatures caused by the intermediate mediums to the heat carrying body. However, in the embodiment in which the multichannel heat exchanger 130 includes a plurality of sub-heat exchange channels 134, the intermediate medium flowing out of the first refrigeration unit 110 flows through one sub-heat exchange channel 134, and the intermediate medium flowing out of the second refrigeration unit 120 flows through another sub-heat exchange channel 134. The controller 60 may separately control heating temperatures caused by the intermediate mediums in the two sub-heat exchange channels 134 to the heat carrying body, and further indirectly control an overall heating temperature caused by the intermediate medium to the heat carrying body.

In some other embodiments, the controller 60 may also separately control the first three-way valve 61 and the second three-way valve 62, to further control overall traffic of the intermediate medium at the multichannel heat exchanger 130. Corresponding to the embodiment in which the multichannel heat exchanger 130 includes the heat exchange channel 131, the heat exchange channel 131 has a maximum traffic limit. The controller 60 needs to perform matching control over the first three-way valve 61 and the second three-way valve 62 to limit the traffic of the intermediate medium that flows into the multichannel heat exchanger 130 within the maximum traffic limit. That is, the control by the controller 60 over the first three-way valve 61 and the second three-way valve 62 further needs to be matched and regulated to ensure that the overall traffic of the intermediate medium in the multichannel heat exchanger 130 is less than the maximum traffic limit. In this case, when the intermediate medium at the first refrigeration unit 110 needs more intensive heat dissipation, the traffic of the intermediate medium that flows into the multichannel heat exchanger 130 from the first refrigeration unit 110 may be properly reduced, so that more of the intermediate medium at the first refrigeration unit 110 flows into its heat dissipation part 30 for heat dissipation, to ensure an overall heat dissipation effect of the intermediate medium in the first refrigeration unit 110. However, to ensure that a sufficient amount of the intermediate medium flows through the heat exchange channel 131, the controller 60 increases traffic of the intermediate medium that flows into the multichannel heat exchanger 130 from the second refrigeration unit 120, and further matches and regulates the first three-way valve 61 and the second three-way valve 62.

It can be understood that, when there are a plurality of refrigeration units in the distributed composite refrigeration system 100, the controller 60 is connected to three-way valves of all of the plurality of refrigeration units, and matches and regulates the plurality of three-way valves to control traffic of the intermediate medium of each refrigeration unit that flows into the multichannel heat exchanger 130. The matching and regulation may be performed based on a temperature value of each refrigeration unit, or may be performed based on a real-time workload of a server 201 in a refrigeration area corresponding to each refrigeration unit, or the controller 60 may further control each three-way valve by combining both the temperature value and the workload. The foregoing control methods all can implement a heating function for the heat carrying body in the external pipe network by using refrigeration waste heat while ensuring an overall refrigeration effect of the equipment room 200 of the data center, thereby implementing energy conservation and emission reduction.

In an embodiment, refer to FIG. 12. The distributed composite refrigeration system 100 in this application may further include a cooling tower 140. The first refrigeration unit 110 further includes a first water cooling component 81. The first water cooling component 81 is thermally connected to the heat dissipation part 30, and is configured to implement a heat dissipation function of the heat dissipation part 30 for the intermediate medium. Specifically, water or a thermally conductive solvent flows through the first water cooling component 81. The first water cooling component 81 is thermally connected to the heat dissipation part 30, so that the water (water is used as an example below) in the first water cooling component 81 may form heat exchange with the intermediate medium in the heat dissipation part 30, to implement the heat dissipation function of the heat dissipation part 30 for the intermediate medium. Further, the first water cooling component 81 is further connected to the cooling tower 140, and the water obtained after heat exchange may flow to the cooling tower 140 for heat dissipation.

Correspondingly, the second refrigeration unit 120 includes a second water cooling component 82. The second water cooling component 82 is thermally connected to the heat dissipation part 30 of the second refrigeration unit 120, and is also connected to the cooling tower 140. Water in the second water cooling component 82 may be configured to perform heat dissipation for the intermediate medium in the second refrigeration unit 120, and the water obtained after heat exchange may also flow to the cooling tower 140 for heat dissipation.

Compared with air-cooled heat dissipation, heat dissipation by the cooling tower 140 features a stronger capability. The embodiment in which the first refrigeration unit 110 and the second refrigeration unit 120 are respectively provided with the first water cooling component 81 and the second water cooling component 82 is applicable to an equipment room 200 of a data center having a higher refrigeration requirement. Alternatively, when the distributed composite refrigeration system 100 includes a plurality of refrigeration units, a manner in which the cooling tower 140 is used for centralized heat dissipation is more efficient than a manner in which an air cooling structure is separately disposed for each refrigeration unit.

In some other embodiments, the distributed composite refrigeration system 100 may further be provided with an integral water cooling component (not shown in the figure). The integral water cooling component is thermally connected to the multichannel heat exchanger 130, and is configured to perform heat dissipation for the multichannel heat exchanger 130. It can be understood that, when the water cooling component is thermally connected to the multichannel heat exchanger 130, the multichannel heat exchanger 130 is thermally connected to both the water cooling component and the external pipe network 300. The water cooling component may also be configured to perform heat dissipation for the intermediate medium in the multichannel heat exchanger 130, thereby regulating the temperature of the intermediate medium or regulating the temperature of the heat carrying body in the external pipe network 300. In this embodiment, the water cooling component and the cooling tower 140 also implement a heat dissipation effect for the intermediate medium, and the water cooling component and the cooling tower 140 may be used in parallel with the heat dissipation part 30 in each refrigeration unit to perform heat dissipation for the intermediate medium, so as to improve a heat dissipation capability of the distributed composite refrigeration system 100 in this application, and more accurately control the temperature of the intermediate medium.

The foregoing descriptions are merely specific embodiments of this application, but the protection scope of this application is not limited thereto. Embodiments in this application and characteristics in embodiments may be mutually combined when they do not conflict with each other. Therefore, the protection scope of this application shall be subject to the protection scope of the claims.

## Claims

1. A distributed composite refrigeration system (100), comprising a multichannel heat exchanger (130) and at least two refrigeration units (110, 120), wherein the at least two refrigeration units are connected to at least two indoor areas (210, 220) in one-to-one correspondences; and
each refrigeration unit comprises a refrigeration part (20), a heat exchange part (40), and a heat dissipation part (30), wherein a refrigerant flows between the refrigeration part (20) and the heat exchange part (40), the refrigeration part uses the refrigerant to refrigerate air to be delivered to the corresponding indoor area, an intermediate medium flows in the heat exchange part (40), the refrigerant and the intermediate medium implement heat exchange at the heat exchange part (40), and the heat exchange part (40) is further separately connected to the heat dissipation part (30) and the multichannel heat exchanger (130), and is configured to deliver the intermediate medium obtained by means of heat exchange to the heat dissipation part (30) and/or the multichannel heat exchanger (130) for heat dissipation, wherein
the multichannel heat exchanger (130) is further thermally connected to an external pipe network (300), and the intermediate medium performs heat exchange with a heat carrying body in the external pipe network at the multichannel heat exchanger (130).

2. The distributed composite refrigeration system according to claim 1, wherein the multichannel heat exchanger (130) comprises a heat exchange channel, each refrigeration unit (110, 120) is connected to the heat exchange channel, and after the intermediate medium in each refrigeration unit (110, 120) converges in the heat exchange channel, the intermediate medium performs heat exchange with the heat carrying body.

3. The distributed composite refrigeration system according to claim 1, wherein the multichannel heat exchanger (130) comprises at least two sub-heat exchange channels (134), the at least two refrigeration units (110, 120) are connected to the at least two sub-heat exchange channels in one-to-one correspondences, and the intermediate medium in each refrigeration unit (110, 120) performs heat exchange with the heat carrying body in the corresponding sub-heat exchange channel (134).

4. The distributed composite refrigeration system according to any one of claims 1 to 3, wherein the multichannel heat exchanger (130) comprises a heat carrying body channel, the heat carrying body channel is connected to the external pipe network (300), and the heat carrying body flows through the heat carrying body channel, and performs heat exchange with the intermediate medium in the multichannel heat exchanger (130).

5. The distributed composite refrigeration system according to any one of claims 1 to 4, wherein the distributed composite refrigeration system further comprises a controller (60), each refrigeration unit further comprises a three-way valve (61), three ports of the three-way valve are respectively connected to the heat exchange part (40), the heat dissipation part (30), and the multichannel heat exchanger (130), and the controller controls the three-way valve to regulate traffic of the intermediate medium that flows into the heat dissipation part (30) and traffic of the intermediate medium that flows into the multichannel heat exchanger (130).

6. The distributed composite refrigeration system according to claim 5, wherein the at least two indoor areas comprise a first area (210), the at least two refrigeration units comprise a first refrigeration unit (110), and the first refrigeration unit is correspondingly connected to the first area; and
the first refrigeration unit further comprises a first temperature sensor (71), wherein the first temperature sensor is configured to monitor a temperature of the first area (210), the first temperature sensor is electrically connected to the controller (60), and the controller controls the three-way valve (61) of the first refrigeration unit (110) based on a temperature value detected by the first temperature sensor (71).

7. The distributed composite refrigeration system according to claim 6, wherein the at least two indoor areas comprise a second area (220), the at least two refrigeration units comprise a second refrigeration unit (120), and the second refrigeration unit is correspondingly connected to the second area; and
the second refrigeration unit comprises a second temperature sensor (72), wherein the second temperature sensor is configured to monitor a temperature of the second area (220), the second temperature sensor is electrically connected to the controller (60), and the controller respectively controls, based on the temperature value detected by the first temperature sensor (71) and a temperature value detected by the second temperature sensor (72), a ratio of traffic of the intermediate medium that flows into the multichannel heat exchanger (130) from the first refrigeration unit (110), to traffic of the intermediate medium that flows into the multichannel heat exchanger (130) from the second refrigeration unit (120).

8. The distributed composite refrigeration system according to any one of claims 1 to 7, wherein the distributed composite refrigeration system comprises a cooling tower (140) and a water cooling component (81) connected to the cooling tower, the water cooling component is thermally connected to the multichannel heat exchanger (130), or the water cooling component is thermally connected to each heat dissipation part (30), a heat exchange medium flows in the water cooling component, the heat exchange medium and the intermediate medium perform heat exchange in the multichannel heat exchanger or each heat dissipation part, and the cooling tower is configured to perform heat dissipation on the heat exchange medium in the water cooling component.

9. The distributed composite refrigeration system according to any one of claims 1 to 8, wherein the refrigeration part (20) comprises an electronic expansion valve (21), an evaporator (22), and a compressor (23) that are sequentially connected, and the refrigerant obtained after heat exchange with the intermediate medium flows into the refrigeration part from a side of the electronic expansion valve.

10. A data center, comprising an equipment room (200) and the distributed composite refrigeration system (100) according to any one of claims 1 to 9, wherein the at least two refrigeration units (110, 120) are connected to at least two indoor areas (210, 220) in the equipment room in one-to-one correspondences.

11. The data center according to claim 10, wherein the equipment room comprises a first area, the at least two refrigeration units comprise a first refrigeration unit (110), and the first refrigeration unit is correspondingly connected to the first area (210);
the distributed composite refrigeration system further comprises a controller (60), each refrigeration unit further comprises a three-way valve (61), and the controller controls the three-way valve to regulate traffic of the intermediate medium that flows into the heat dissipation part and traffic of the intermediate medium that flows into the multichannel heat exchanger; and
the controller is communicatively connected to a server in the first area, and the controller further controls the three-way valve of the first refrigeration unit based on a workload of the server in the first area.

12. The data center according to claim 11, wherein the equipment room comprises a second area, the at least two refrigeration units comprise a second refrigeration unit (120), and the second refrigeration unit is correspondingly connected to the second area (220); and
the controller is communicatively connected to a server in the second area, and the controller separately controls, based on the workload of the server in the first area and a workload of the server in the second area, a ratio of traffic of the intermediate medium that flows into the multichannel heat exchanger from the first refrigeration unit, to traffic of the intermediate medium that flows into the multichannel heat exchanger from the second refrigeration unit.

## Patentansprüche

1. Verteiltes Verbundkühlsystem (100), umfassend einen Mehrkanalwärmetauscher (130) und mindestens zwei Kühleinheiten (110, 120), wobei die mindestens zwei Kühleinheiten mit mindestens zwei Innenbereichen (210, 220) in Eins-zu-eins-Entsprechungen verbunden sind; und
jede Kühleinheit einen Kühlteil (20), einen Wärmeaustauschteil (40) und einen Wärmeableitungsteil (30) umfasst, wobei ein Kühlmittel zwischen dem Kühlteil (20) und dem Wärmeaustauschteil (40) strömt, der Kühlteil das Kühlmittel verwendet, um dem entsprechenden Innenbereich zuzuführende Luft zu kühlen, ein Zwischenmedium in dem Wärmeaustauschteil (40) strömt, das Kühlmittel und das Zwischenmedium einen Wärmeaustausch an dem Wärmeaustauschteil (40) durchführen und der Wärmeaustauschteil (40) ferner getrennt mit dem Wärmeableitungsteil (30) und dem Mehrkanalwärmetauscher (130) verbunden ist und dazu konfiguriert ist, das mittels des Wärmeaustausches erlangte Zwischenmedium dem Wärmeableitungsteil (30) und/oder dem Mehrkanalwärmetauscher (130) zur Wärmeableitung zuzuführen,
wobei
der Mehrkanalwärmetauscher (130) ferner thermisch mit einem externen Rohrnetz (300) verbunden ist und das Zwischenmedium einen Wärmeaustausch mit einem Wärmeträgerkörper in dem externen Rohrnetz an dem Mehrkanalwärmetauscher (130) durchführt.

2. Verteiltes Verbundkühlsystem nach Anspruch 1, wobei der Mehrkanalwärmetauscher (130) einen Wärmeaustauschkanal umfasst, jede Kühleinheit (110, 120) mit dem Wärmeaustauschkanal verbunden ist und nachdem das Zwischenmedium in jeder Kühleinheit (110, 120) in dem Wärmeaustauschkanal zusammenläuft, das Zwischenmedium einen Wärmeaustausch mit dem Wärmeträgerkörper durchführt.

3. Verteiltes Verbundkühlsystem nach Anspruch 1, wobei der Mehrkanalwärmetauscher (130) mindestens zwei Unterwärmeaustauschkanäle (134) umfasst, die mindestens zwei Kühleinheiten (110, 120) mit den mindestens zwei Unterwärmeaustauschkanälen in Eins-zu-eins-Entsprechungen verbunden sind und das Zwischenmedium in jeder Kühleinheit (110, 120) einen Wärmeaustausch mit dem Wärmeträgerkörper in dem entsprechenden Unterwärmeaustauschkanal (134) durchführt.

4. Verteiltes Verbundkühlsystem nach einem der Ansprüche 1 bis 3, wobei der Mehrkanalwärmetauscher (130) einen Wärmeträgerkörperkanal umfasst, der Wärmeträgerkörperkanal mit dem externen Rohrnetz (300) verbunden ist und der Wärmeträgerkörper durch den Wärmeträgerkörperkanal strömt und einen Wärmeaustausch mit dem Zwischenmedium in dem Mehrkanalwärmetauscher (130) durchführt.

5. Verteiltes Verbundkühlsystem nach einem der Ansprüche 1 bis 4, wobei das verteilte Verbundkühlsystem ferner eine Steuerung (60) umfasst, jede Kühleinheit ferner ein Dreiwegeventil (61) umfasst, drei Anschlüsse des Dreiwegeventils jeweils mit dem Wärmeaustauschteil (40), dem Wärmeableitungsteil (30) und dem Mehrkanalwärmetauscher (130) verbunden sind und die Steuerung das Dreiwegeventil steuert, um den Verkehr des Zwischenmediums, das in den Wärmeableitungsteil (30) strömt, und den Verkehr des Zwischenmediums, das in den Mehrkanalwärmetauscher (130) strömt, zu regulieren.

6. Verteiltes Verbundkühlsystem nach Anspruch 5, wobei die mindestens zwei Innenbereiche einen ersten Bereich (210) umfassen, die mindestens zwei Kühleinheiten eine erste Kühleinheit (110) umfassen und die erste Kühleinheit entsprechend mit dem ersten Bereich verbunden ist; und
die erste Kühleinheit ferner einen ersten Temperatursensor (71) umfasst, wobei der erste Temperatursensor dazu konfiguriert ist, eine Temperatur des ersten Bereichs (210) zu überwachen, der erste Temperatursensor elektrisch mit der Steuerung (60) verbunden ist und die Steuerung das Dreiwegeventil (61) der ersten Kühleinheit (110) basierend auf einem von dem ersten Temperatursensor (71) erfassten Temperaturwert steuert.

7. Verteiltes Verbundkühlsystem nach Anspruch 6, wobei die mindestens zwei Innenbereiche einen zweiten Bereich (220) umfassen, die mindestens zwei Kühleinheiten eine zweite Kühleinheit (120) umfassen und die zweite Kühleinheit entsprechend mit dem zweiten Bereich verbunden ist; und
die zweite Kühleinheit einen zweiten Temperatursensor (72) umfasst, wobei der zweite Temperatursensor dazu konfiguriert ist, eine Temperatur des zweiten Bereichs (220) zu überwachen, der zweite Temperatursensor elektrisch mit der Steuerung (60) verbunden ist und die Steuerung jeweils basierend auf dem von dem ersten Temperatursensor (71) erfassten Temperaturwert und einem von dem zweiten Temperatursensor (72) erfassten Temperaturwert ein Verhältnis des Verkehrs des Zwischenmediums,
das aus der ersten Kühleinheit (110) in den Mehrkanalwärmetauscher (130) strömt, zu dem Verkehr des Zwischenmediums, das aus der zweiten Kühleinheit (120) in den Mehrkanalwärmetauscher (130) strömt, steuert.

8. Verteiltes Verbundkühlsystem nach einem der Ansprüche 1 bis 7, wobei das verteilte Verbundkühlsystem einen Kühlturm (140) und eine mit dem Kühlturm verbundene Wasserkühlkomponente (81) umfasst, wobei die Wasserkühlkomponente thermisch mit dem Mehrkanalwärmetauscher (130) verbunden ist oder die Wasserkühlkomponente thermisch mit jedem Wärmeableitungsteil (30) verbunden ist, ein Wärmeaustauschmedium in der Wasserkühlkomponente strömt, das Wärmeaustauschmedium und das Zwischenmedium einen Wärmeaustausch in dem Mehrkanalwärmetauscher oder jedem Wärmeableitungsteil durchführen und der Kühlturm dazu konfiguriert ist, eine Wärmeableitung an dem Wärmeaustauschmedium in der Wasserkühlkomponente durchzuführen.

9. Verteiltes Verbundkühlsystem nach einem der Ansprüche 1 bis 8, wobei der Kühlteil (20) ein elektronisches Expansionsventil (21), einen Verdampfer (22) und einen Kompressor (23) umfasst, die nacheinander verbunden sind, und das nach dem Wärmeaustausch mit dem Zwischenmedium erlangte Kühlmittel von einer Seite des elektronischen Expansionsventils in den Kühlteil strömt.

10. Datenzentrum, umfassend einen Geräteraum (200) und das verteilte Verbundkühlsystem (100) nach einem der Ansprüche 1 bis 9, wobei die mindestens zwei Kühleinheiten (110, 120) mit mindestens zwei Innenbereichen (210, 220) in dem Geräteraum in Eins-zu-eins-Entsprechungen verbunden sind.

11. Datenzentrum nach Anspruch 10, wobei der Geräteraum einen ersten Bereich umfasst, die mindestens zwei Kühleinheiten eine erste Kühleinheit (110) umfassen und die erste Kühleinheit entsprechend mit dem ersten Bereich (210) verbunden ist;
das verteilte Verbundkühlsystem ferner eine Steuerung (60) umfasst, jede Kühleinheit ferner ein Dreiwegeventil (61) umfasst und die Steuerung das Dreiwegeventil steuert, um den Verkehr des Zwischenmediums, das in den Wärmeableitungsteil strömt, und den Verkehr des Zwischenmediums, das in den Mehrkanalwärmetauscher strömt, zu regulieren; und
die Steuerung kommunikativ mit einem Server in dem ersten Bereich verbunden ist und die Steuerung ferner das Dreiwegeventil der ersten Kühleinheit basierend auf einer Arbeitslast des Servers in dem ersten Bereich steuert.

12. Datenzentrum nach Anspruch 11, wobei der Geräteraum einen zweiten Bereich umfasst, die mindestens zwei Kühleinheiten eine zweite Kühleinheit (120) umfassen und die zweite Kühleinheit entsprechend mit dem zweiten Bereich (220) verbunden ist; und die Steuerung kommunikativ mit einem Server in dem zweiten Bereich verbunden ist und die Steuerung basierend auf der Arbeitslast des Servers in dem ersten Bereich und einer Arbeitslast des Servers in dem zweiten Bereich ein Verhältnis des Verkehrs des Zwischenmediums, das aus der ersten Kühleinheit in den Mehrkanalwärmetauscher strömt, zu dem Verkehr des Zwischenmediums, das aus der zweiten Kühleinheit in den Mehrkanalwärmetauscher strömt, getrennt steuert.

## Revendications

1. Système distribué de réfrigération composite (100), comprenant un échangeur de chaleur à plusieurs canaux (130) et au moins deux unités de réfrigération (110, 120), dans lequel les au moins deux unités de réfrigération sont reliées à au moins deux zones intérieures (210, 220) dans des correspondances biunivoques ; et
chaque unité de réfrigération comprend une partie de réfrigération (20), une partie d'échange de chaleur (40) et une partie de dissipation de chaleur (30), dans lequel un réfrigérant circule entre la partie de réfrigération (20) et la partie d'échange de chaleur (40), la partie de réfrigération utilise le réfrigérant pour réfrigérer de l'air à fournir à la zone intérieure correspondante, un fluide intermédiaire circule dans la partie d'échange de chaleur (40), le réfrigérant et le milieu intermédiaire réalisent un échange de chaleur au niveau de la partie d'échange de chaleur (40), et la partie d'échange de chaleur (40) est en outre reliée séparément à la partie de dissipation de chaleur (30) et à l'échangeur de chaleur à plusieurs canaux (130), et est configurée pour fournir le milieu intermédiaire obtenu au moyen d'un échange de chaleur à la partie de dissipation de chaleur (30) et/ou à l'échangeur de chaleur à plusieurs canaux (130) pour la dissipation de chaleur, dans lequel l'échangeur de chaleur à plusieurs canaux (130) est en outre relié thermiquement à un réseau de tuyaux externe (300), et le milieu intermédiaire effectue un échange de chaleur avec un corps caloporteur dans le réseau de tuyaux externe au niveau de l'échangeur de chaleur à plusieurs canaux (130).

2. Système distribué de réfrigération composite selon la revendication 1, dans lequel l'échangeur de chaleur à plusieurs canaux (130) comprend un canal d'échange de chaleur, chaque unité de réfrigération (110, 120) est reliée au canal d'échange de chaleur, et après que le milieu intermédiaire dans chaque réfrigération l'unité (110, 120) converge dans le canal d'échange de chaleur, le milieu intermédiaire effectue un échange de chaleur avec le corps caloporteur.

3. Système distribué de réfrigération composite selon la revendication 1, dans lequel l'échangeur de chaleur à plusieurs canaux (130) comprend au moins deux sous-canaux d'échange de chaleur (134), les au moins deux unités de réfrigération (110, 120) sont reliées aux au moins deux sous-canaux d'échange de chaleur en correspondances biunivoques, et le milieu intermédiaire dans chaque unité de réfrigération (110, 120) effectue un échange de chaleur avec le corps caloporteur dans le sous-canal d'échange de chaleur correspondant (134).

4. Système distribué de réfrigération composite selon l'une quelconque des revendications 1 à 3, dans lequel l'échangeur de chaleur à plusieurs canaux (130) comprend un canal de corps caloporteur, le canal de corps caloporteur est relié au réseau de tuyaux externe (300), et le corps caloporteur s'écoule à travers le canal de corps caloporteur et effectue un échange de chaleur avec le milieu intermédiaire dans l'échangeur de chaleur à plusieurs canaux (130).

5. Système distribué de réfrigération composite selon l'une quelconque des revendications 1 à 4, dans lequel le système distribué de réfrigération composite comprend en outre un dispositif de commande (60), chaque unité de réfrigération comprend en outre une vanne à trois voies (61), trois orifices de la vanne à trois voies sont respectivement reliés à la partie d'échange de chaleur (40), à la partie de dissipation de chaleur (30) et à l'échangeur de chaleur à plusieurs canaux (130), et le dispositif de commande commande la vanne à trois voies pour réguler la circulation du milieu intermédiaire qui s'écoule dans la partie de dissipation de chaleur (30) et la circulation du milieu intermédiaire qui s'écoule dans l'échangeur de chaleur à plusieurs canaux (130).

6. Système distribué de réfrigération composite selon la revendication 5, dans lequel les au moins deux zones intérieures comprennent une première zone (210), les au moins deux unités de réfrigération comprennent une première unité de réfrigération (110), et la première unité de réfrigération est reliée de manière correspondante à la première zone ; et
la première unité de réfrigération comprend en outre un premier capteur de température (71), dans lequel le premier capteur de température est configuré pour surveiller une température de la première zone (210), le premier capteur de température est relié électriquement au dispositif de commande (60), et le dispositif de commande commande la vanne à trois voies (61) de la première unité de réfrigération (110) sur la base d'une valeur de température détectée par le premier capteur de température (71).

7. Système distribué de réfrigération composite selon la revendication 6, dans lequel les au moins deux zones intérieures comprennent une seconde zone (220), les au moins deux unités de réfrigération comprennent une seconde unité de réfrigération (120), et la seconde unité de réfrigération est reliée de manière correspondante à la seconde zone ; et
la seconde unité de réfrigération comprend un second capteur de température (72), dans lequel le second capteur de température est configuré pour surveiller une température de la seconde zone (220), le second capteur de température est électriquement relié au dispositif de commande (60), et le dispositif de commande respectivement commande, sur la base de la valeur de température détectée par le premier capteur de température (71) et d'une valeur de température détectée par le second capteur de température (72), un rapport de circulation du milieu intermédiaire qui s'écoule dans l'échangeur de chaleur à plusieurs canaux (130) depuis la première unité de réfrigération (110), à la circulation du milieu intermédiaire qui s'écoule dans l'échangeur de chaleur à plusieurs canaux (130) depuis la seconde unité de réfrigération (120).

8. Système distribué de réfrigération composite selon l'une quelconque des revendications 1 à 7, dans lequel le système distribué de réfrigération composite comprend une tour de refroidissement (140) et un composant de refroidissement par eau (81) relié à la tour de refroidissement, le composant de refroidissement par eau est thermiquement relié à l'échangeur de chaleur à plusieurs canaux (130), ou le composant de refroidissement par eau est relié thermiquement à chaque partie de dissipation de chaleur (30), un milieu d'échange de chaleur circule dans le composant de refroidissement par eau, le milieu d'échange de chaleur et le milieu intermédiaire effectuent un échange de chaleur dans l'échangeur de chaleur à plusieurs canaux ou dans chaque partie de dissipation de chaleur, et la tour de refroidissement est configurée pour effectuer une dissipation de chaleur sur le milieu d'échange de chaleur dans le composant de refroidissement à eau.

9. Système distribué de réfrigération composite selon l'une quelconque des revendications 1 à 8, dans lequel la partie de réfrigération (20) comprend un détendeur électronique (21), un évaporateur (22) et un compresseur (23) reliés séquentiellement, et le réfrigérant obtenu après échange de chaleur avec le milieu intermédiaire s'écoule dans la partie de réfrigération à partir d'un côté du détendeur électronique.

10. Centre de données, comprenant une salle d'équipement (200) et le système distribué de réfrigération composite (100) selon l'une quelconque des revendications 1 à 9, dans lequel les au moins deux unités de réfrigération (110, 120) sont reliées aux au moins deux zones intérieures (210, 220) dans la salle d'équipement dans des correspondances biunivoques.

11. Centre de données selon la revendication 10, dans lequel la salle d'équipement comprend une première zone, les au moins deux unités de réfrigération comprennent une première unité de réfrigération (110), et la première unité de réfrigération est reliée de manière correspondante à la première zone (210) ;
le système distribué de réfrigération composite comprend en outre un dispositif de commande (60), chaque unité de réfrigération comprend en outre une vanne à trois voies (61), et le dispositif de commande commande la vanne à trois voies pour réguler la circulation du milieu intermédiaire qui s'écoule dans la partie de dissipation de chaleur et la circulation du milieu intermédiaire qui s'écoule dans l'échangeur de chaleur à plusieurs canaux ; et
le dispositif de commande est relié en communication à un serveur dans la première zone, et le dispositif de commande commande en outre la vanne à trois voies de la première unité de réfrigération sur la base d'une charge de travail du serveur dans la première zone.

12. Centre de données selon la revendication 11, dans lequel la salle d'équipement comprend une seconde zone, les au moins deux unités de réfrigération comprennent une seconde unité de réfrigération (120), et la seconde unité de réfrigération est reliée de manière correspondante à la seconde zone (220) ; et le dispositif de commande est relié en communication à un serveur dans la seconde zone, et le dispositif de commande commande séparément, sur la base de la charge de travail du serveur dans la première zone et d'une charge de travail du serveur dans la seconde zone, un rapport de circulation du milieu intermédiaire qui s'écoule dans l'échangeur de chaleur à plusieurs canaux depuis la première unité de réfrigération, à la circulation du milieu intermédiaire qui s'écoule dans l'échangeur de chaleur à plusieurs canaux depuis la seconde unité de réfrigération.
